# EUROPEAN PATENT APPLICATION

(11) **EP 4 815 706 A1**
(43) Date of publication of application: **30.09.2026**
(21) Application number: 25224296.1
(22) Date of filing: 17.12.2025
(51) Int. Cl.: H10W 20/20, H10W 20/00, H10D 30/00, H10D 62/10, H10D 84/85, H10W 20/41, H10W 20/40, H10D 84/01

(54) **DEEP VIA FORMATION TECHNIQUES**

(30) Priority: 25.03.2025 US 202519089375
(71) Applicant: Intel Corporation, Santa Clara, CA 95054 (US)
(72) Inventor: ZHANG, Yang, Rio Rancho, 87124 (US); YANG, Xiandong, Albuquerque, 87113 (US); PULS, Conor P., Portland, 97229 (US); AMIN, Payam, Portland, 97229 (US); MARINKOVIC, Bozidar, Portland, 97225 (US); CHU, Tao, Portland, 97229 (US); XU, Guowei, Portland, 97229 (US); ZHANG, Kan, Hillsboro, 97123 (US); ZHANG, Feng, Portland, 97229 (US); HUNG, Ting-Hsiang, Santa Clara, 95051 (US); YEUNG, Chun Wing, Portland, 97229 (US); LIN, Chia-Ching, Portland, 97229 (US); LIN, Chung-Hsun, Portland, 97229 (US); GHANI, Tahir, Portland, 97229 (US)
(74) Representative: 2SPL Patentanwälte PartG mbB

(57) **Abstract**

IC structures fabricated using deep via formation techniques described herein may have improved backside uniformity. In one example, a method of forming a deep via involves forming an opening that stops on the substrate, providing a mask material on the substrate in the opening, providing a liner in the opening on the sidewalls and over the mask material, removing the mask material from the opening and providing a conductive material in the partially lined opening. In one example, the partial liner on the sidewalls of the opening extends only part of the way down the via opening.

## Description

### Background

For the past several decades, the scaling of features in integrated circuits (ICs) has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize fabrication and performance of each component (e.g., the conductive interconnects for signaling, power delivery, and ground) is becoming increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon field-effect transistor (FET), according to one embodiment of the present disclosure.
FIG. 2 is a top-down view of an IC device fabricated using deep via formation techniques for increased backside uniformity, according to one embodiment of the present disclosure.
FIGS. 3A-3C are cross-sectional side views along different cross-sections of the IC device of FIG. 2, according to some embodiments of the present disclosure.
FIG. 4 is an example cross-sectional side view of an IC device fabricated using deep via formation techniques for increased backside uniformity, according to some embodiments of the present disclosure.
FIG. 5 is a flow diagram of an example method for fabricating an IC structure using deep via formation techniques for increased backside uniformity, in accordance with some embodiments.
FIGS. 6A-6G provide cross-sectional side views at various stages in the fabrication of an example IC structure according to the method of FIG. 5, in accordance with some embodiments.
FIG. 7 is a top view of a wafer and dies that may include any of the IC devices disclosed herein, in accordance with any of the embodiments disclosed herein.
FIG. 8 is a side, cross-sectional view of an IC package that may include any of the IC devices disclosed herein, in accordance with various embodiments.
FIG. 9 is a side, cross-sectional view of an IC device assembly that may include any of the IC devices disclosed herein, in accordance with any of the embodiments disclosed herein.
FIG. 10 is a block diagram of an example electrical device that may include any of the IC devices disclosed herein, in accordance with any of the embodiments disclosed herein.

### Detailed Description

Disclosed herein are IC structures and devices fabricated using deep via formation techniques for increase backside uniformity. In some embodiments, vias (e.g., deep trench vias) may be used for backside power, signal, or ground delivery. The systems, methods, and devices of this disclosure each have several innovative aspects, no single one of which is solely responsible for all desirable attributes disclosed herein. Details of one or more implementations of the subject matter described in this specification are set forth in the description below and the accompanying drawings.

As IC structures become more compact with smaller feature sizes and higher device density, new challenges arise in the fabrication processes of such devices. For example, in some IC structures, conductive vias are placed between the gate stacks of transistors, such as nanoribbon-based transistors. Formation of conductive vias adjacent to or between nanoribbon-based transistors may involve forming a via opening adjacent to and/or between nanoribbon stacks, where the opening typically protrudes into the substrate. A liner may then be provided on the bottom and on the sidewalls of the opening, and the lined opening may be filled with an electrically conductive material. Thus, the conductive via wrapped by a liner at the bottom may protrude into the underlying substrate. In some examples, there can be significant variability in the extent to which the conductive via protrudes into the substrate. Such variability can result in defects during a subsequent polish process, such as over-polishing (which may result in, e.g., unwanted loss of an insulator material) or under-polishing (which may result in, e.g., a portion of the substrate remaining after the polish process).

According to examples described herein, a "grounded deep via" in which the via opening stops on the substrate and the electrically conductive material is deposited on the substrate in the opening can enable improved backside uniformity. In one example, a method of forming a deep via involves forming an opening that stops on the substrate, providing a mask material on the substrate in the opening, providing a liner in the opening on the sidewalls and over the mask material, removing the mask material from the opening and providing a conductive material in the partially lined opening. In one example, the partial liner on the sidewalls of the opening extends only part of the way down the via opening. For example, an IC structure may include a first conductive element (e.g., a conductive pad, conductive via, or other conductive element) in a first layer, a second conductive element in a second layer over the first layer, and a conductive via between the first conductive element and the second conductive element. In one example, the conductive via includes a first portion (e.g., a bottom portion) and a second portion (e.g., a top portion). A liner including an insulator material is on the sidewalls of the conductive via, where the liner is limited to the second portion (e.g., top portion) of the conductive via, and absent from the sidewalls of the first portion (e.g., bottom portion) of the conductive via.

While some descriptions are provided herein with respect to the use of deep trench vias for backside power delivery, embodiments of the present disclosure are equally applicable to using vias for backside signal or ground delivery, as well as to vias being used for purposes of delivering power, signal, or ground to IC components from the front side.

IC structures as described herein, in particular IC structures fabricated using deep via formation techniques for increased backside uniformity, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of the presence of IC structures fabricated using deep via formation techniques for increased backside uniformity as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

IC structures including deep vias formed in accordance with techniques described herein may also include transistors of any architecture, such as any non-planar or planar architecture. Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

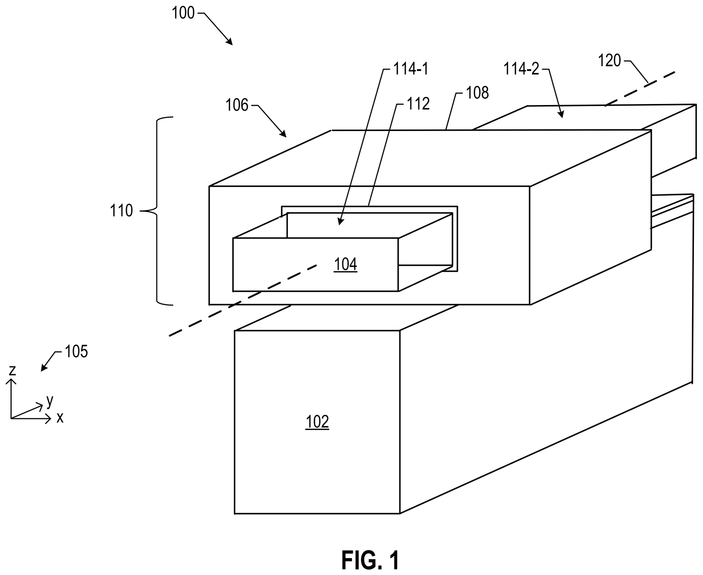

Nanoribbon transistors may be particularly advantageous for continued scaling of complementary metal-oxide-semiconductor (CMOS) technology nodes due to the potential to form gates on all four sides of a channel material (hence, such transistors are sometimes referred to as "gate all around" transistors). Therefore, some IC structures illustrated herein show nanoribbon transistors as an example (e.g., IC structures shown in FIG. 1, FIG. 3A-3C, and FIG. 4), although IC structures fabricated with deep via formation techniques as described herein may include other devices instead of or in addition to nanoribbon transistors, and are not limited to such transistors.

As used herein, the term "nanoribbon" refers to an elongated structure of a semiconductor material having a longitudinal axis parallel to a support structure (e.g., a substrate, a die, a chip, or a wafer) over which such a structure is built. Typically, a length of a such a structure (i.e., a dimension measured along the longitudinal axis, shown in the present drawings to be along the y-axis of an example x-y-z coordinate system 105 shown in FIG. 1) is greater than each of a width (i.e., a dimension measured along the x-axis of the coordinate system 105) and a thickness/height (i.e., a dimension measured along the z-axis of the coordinate system 105). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections. In the present disclosure, the term "nanoribbon" is used to refer to all such nanowires, nanoribbons, and nanosheets, as well as elongated semiconductor structures with a longitudinal axis parallel to the support structures and with having transverse cross-sections of any geometry (e.g., transverse cross-sections in the shape of an oval or a polygon with rounded corners). A transistor may then be described as a "nanoribbon transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with source and drain regions of a transistor provided on either side of the channel material.

FIG. 1 provides a perspective view of an example IC structure 100 with a nanoribbon transistor 110, according to some embodiments of the present disclosure. As shown in FIG. 1, the IC structure 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2, on either side of the gate stack 106. One of the S/D regions 114-1, 114-2 is a source region and the other one is a drain region. However, because, as is common in the field of FETs, designations of source and drain are often interchangeable, they are simply referred to herein as a first S/D region 114-1 and a second S/D region 114-2.

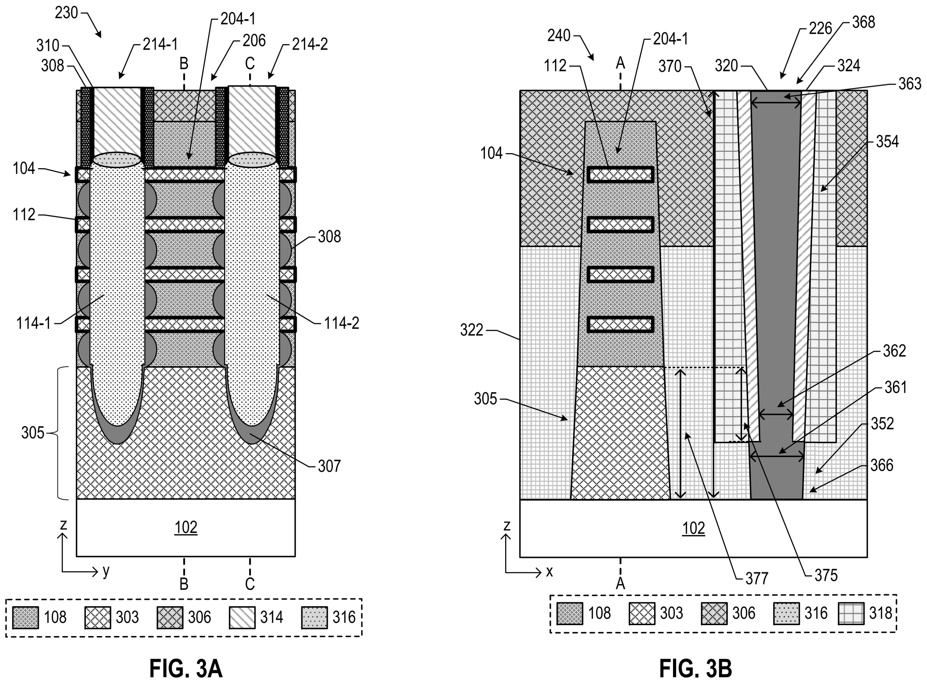

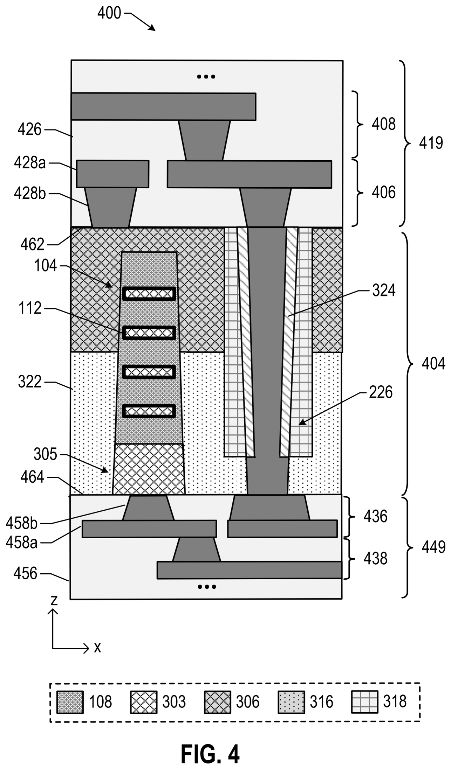

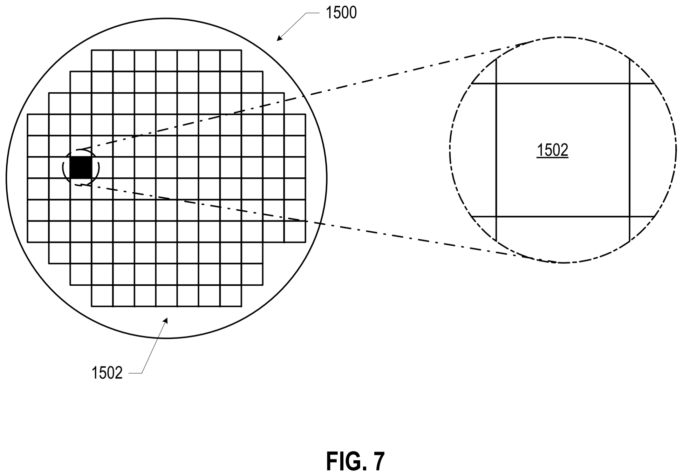

Implementations of the present disclosure may be formed or carried out on any suitable support 102, such as a substrate, a die, a wafer, or a chip. The support 102 may, e.g., be the wafer 1500 of FIG. 7, discussed below, and may be, or be included in, a die, e.g., the singulated die 1502 of FIG. 7, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC structure fabricated using deep via formation techniques for increased backside uniformity as described herein may be built falls within the spirit and scope of the present disclosure. Although only one nanoribbon 104 is shown in FIG. 1, the IC structure 100 may include a stack of such nanoribbons where a plurality of nanoribbons 104 are stacked above one another. For example, FIGS. 3A-3C and FIG. 4 show IC structures that may be examples of the IC structure 100. In some embodiments, a portion of the support 102 right below the lowest nanoribbon 104 of the stack may be shaped as a subfin extending away from a base, as is known in the field of nanoribbon transistors.

The nanoribbon 104 may take the form of a nanowire or nanoribbon, for example. In some embodiments, an area of a transversal cross-section of the nanoribbon 104 (i.e., an area in the x-z plane of an x-y-z coordinate system 105 shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width of the nanoribbon 104 (i.e., a dimension measured in a plane parallel to the support 102 and in a direction perpendicular to the longitudinal axis 120 of the nanoribbon 104, e.g., along the x-axis of the coordinate system 105) may be at least about 3 times larger than a height of the nanoribbon 104 (i.e., a dimension measured in a plane perpendicular to the support 102, e.g., along the z-axis of the coordinate system 105), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., front-end components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include one or more gate electrode materials, where the choice of the gate electrode materials may depend on whether the transistor 110 is a PMOS transistor or an NMOS transistor For a PMOS transistor, gate electrode materials that may be used in different portions of the gate electrode material 108 may include, but are not limited to, tungsten, ruthenium, palladium, platinum, cobalt, nickel, and conductive metal oxides (e.g., ruthenium oxide), conductive metal nitrides (e.g., titanium nitride). For an NMOS transistor, gate electrode materials that may be used in different portions of the gate electrode material 108 include, but are not limited to, tungsten, hafnium, zirconium, titanium, tantalum, aluminum, alloys of these metals, and carbides of these metals (e.g., hafnium carbide, zirconium carbide, titanium carbide, tantalum carbide, and aluminum carbide, titanium aluminum carbide). In one example in which both an NMOS transistor and a PMOS transistor include gate materials that include tungsten, the gate electrode material including tungsten for the NMOS transistor may include fluorine, and the gate electrode material including tungsten for the PMOS transistor may be fluorine-free (e.g., fluorine may be substantially absent from a gate electrode material including tungsten for a PMOS transistor). In some embodiments, the gate electrode material 108 may include a stack of a plurality of gate electrode materials, where zero or more materials of the stack are workfunction (WF) materials and at least one material of the stack is a fill metal layer. Further materials/layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabrication of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and S/D contacts of the transistor 110 and could be made of a low-k dielectric material, some examples of which have been provided above.

Turning to the S/D regions 114-1, 114-2 of the transistor 110, in some embodiments, the S/D regions may be highly doped, e.g., with dopant concentrations of about 10²¹ cm⁻³, in order to advantageously form Ohmic contacts with the respective S/D contacts (not shown in FIG. 1), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. Even when doped to realize threshold voltage tuning as described herein, the channel portions of transistors typically include semiconductor materials with doping concentrations significantly smaller than those of the S/D regions 114-1, 114-2.

The S/D regions 114-1, 114-2 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114-1, 114-2. An epitaxial deposition process may then be carried out to fill the recesses with material that is used to fabricate the S/D regions 114-1, 114-2. In some implementations, the S/D regions 114-1, 114-2 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114-1, 114-2 may be formed using one or more alternate semiconductor materials such as germanium or a group III-V material or alloy. And in further embodiments, one or more layers of metal and/or metal alloys may be used to form the S/D regions 114-1, 114-2. In some embodiments, a distance between the first and second S/D regions 114-1 and 114-2 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114-1, 114-2 of the transistor 110, additional layers such as a spacer layer around the gate electrode of the transistor 110, etc.). For example, although not specifically illustrated in FIG. 1, a dielectric spacer may be provided between a first S/D contact (which may also be referred to as a "first S/D electrode") coupled to a first S/D region 114-1 of the transistor 110 and the gate stack 106 as well as between a second S/D contact (which may also be referred to as a "second S/D electrode") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

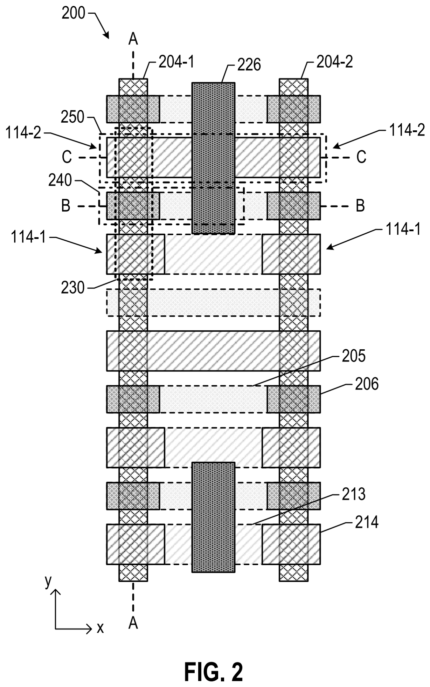

FIG. 2 is a top-down view of an IC structure 200 that may include deep vias fabricated in accordance with techniques described herein. Some of the materials are not shown in the top-down view in order to not obscure the drawing.

As shown in FIG. 2, the IC structure 200 may include two nanoribbon stacks 204-1 and 204-2 if the transistors to be implemented in the IC structure 200 are nanoribbon transistors such as the one illustrated in FIG. 1. Alternatively, what is now shown as nanoribbon stacks 204-1 and 204-2 could be fins if the transistors to be implemented in the IC structure 200 are FinFETs. The nanoribbon stacks 204-1, 204-2 may include stacks of one or more nanoribbons 104 as described above and may be provided over a support such as the support 102 (not specifically shown in FIG. 2). The nanoribbon stacks 204-1, 204-2 may extend substantially parallel to one another, e.g., along the y-axis of the coordinate system 105, consistent with the illustration of FIG. 1. Metal gate lines 205 (shown in FIG. 2 to be within dashed contours) and S/D contact lines 213 may extend substantially perpendicular to the nanoribbon stacks 204-1, 204-2 and substantially parallel to one another, e.g., along the x-axis of the coordinate system 105. FIG. 2 illustrates that the metal gate lines 205 and the S/D contact lines 213 may be provided in an alternating manner. Metal gate lines 205 may be cut and removed where the deep trench vias are placed, so that gate contacts 206 effectively act as portions of the metal lines 205. In FIG. 2, portions of the metal gate lines 205 are shown with dashed contours, indicating that these are the portions where the metal gate lines 205 have been removed. The gate contacts 206 are in conductive contact with the gate stacks 106 (which are underneath the gate contacts 206 and, therefore, not seen in the view of FIG. 2) provided over channel portions of the nanoribbon stacks 204-1, 204-2, providing electrical connectivity to the gates of the nanoribbon transistors. Thus, portions of the gate contacts 206 intersecting the gate stacks 106 are in conductive contact with the gate stacks 106 and serve as gate contacts for the transistors.

Similarly, S/D contact lines 213 may be cut and removed where the deep trench vias are placed, so that S/D contacts 214 effectively act as portions of the S/D contact lines 213. In FIG. 2, portions of the S/D contact lines 213 are shown with dashed contours, indicating that these are the portion where the S/D contact lines 213 have been removed. The S/D contacts 214 are provided over S/D regions (e.g., the S/D regions 114-1 and 114-2 (which are underneath the S/D contacts 214 and, therefore, not seen in the view of FIG. 2) of the nanoribbon stacks 204-1, 204-2, providing electrical connectivity to the S/D regions of the nanoribbon transistors. Thus, portions of the S/D contacts 214 intersecting the S/D regions are in conductive contact with the S/D regions and serve as S/D contacts for the transistors.

FIG. 2 further illustrates that deep trench vias 226 may be provided in the vicinity of the transistors formed on the basis of the nanoribbon stacks 204-1, 204-2. Two instances of the deep trench vias 226 are shown in FIG. 2, but, in other embodiments, any other number of one or more deep trench vias 226 may be included in the IC structure 200. Similarly, while a particular arrangement of gate stacks 106, metal gate lines 205, gate contacts 206, S/D contact lines 213, and S/D contacts 214 is shown in FIG. 1 and FIG. 2, in other embodiments, these elements may be arranged differently within the IC structure 200.

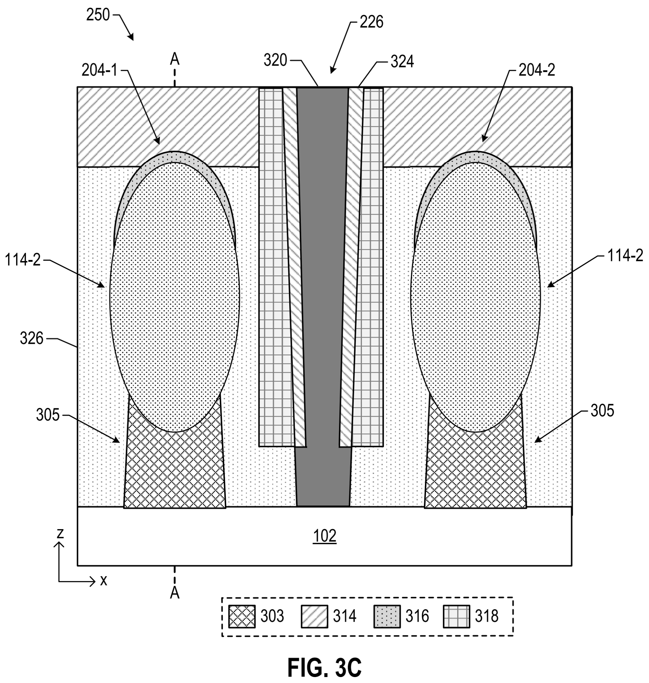

In order to further illustrate details of the IC structure 200, FIG. 2 shows a portion 230 (illustrated with a dotted contour), a portion 240 (illustrated with a dot-dashed contour), and a portion 250 (illustrated with a double-dot-dashed contour). The portion 230 indicates an approximate outline of an example transistor such as the transistor 110, provided over the nanoribbon stack 204-1. The portion 240 illustrates a portion of the IC structure 200 with a gate contact 206 provided over a gate stack 106 over a channel portion of the nanoribbon stack 204-1 and a deep trench via 226. FIGS. 3A-3C are cross-sectional side views along different cross-sections of the IC structure 200 of FIG. 2, according to some embodiments of the present disclosure. In particular, FIG. 3A illustrates a cross-sectional side view of the portion 230 along a plane AA shown in FIG. 2, FIG. 3B illustrates a cross-sectional side view of the portion 240 along a plane BB shown in FIG. 2, and FIG. 3C illustrates a cross-sectional side view of the portion 250 along a plane CC shown in FIG. 2. A number of elements referred to in the description of FIGS. 3A-3C and FIG. 4 with reference numerals are illustrated in these drawings with different patterns, with a legend showing the correspondence between the reference numerals and patterns being provided at the bottom of each drawing page containing FIGS. 3A-3C and FIG. 4. For example, the legend illustrates that FIGS. 3A-3C use different patterns to show a gate electrode material 108, a semiconductor material 303, an electrically conductive material 306 of a gate contact 206, and so on.

As shown in FIG. 3A, the portion 230 includes a transistor similar to the transistor 110 but built on the basis of a nanoribbon stack 204-1 of a plurality of nanoribbons 104 instead of just one nanoribbon 104 as shown in FIG. 1. While four nanoribbons 104 are shown to be included in the nanoribbon stack 204-1, in other embodiments, fewer nanoribbons 104 or more nanoribbons 104 may be included. FIG. 3A illustrates a semiconductor material 303 as the material of the nanoribbons 104, further illustrating a subfin 305 of the semiconductor material 303 below the nanoribbon stack 204-1, although in some embodiments the nanoribbons 104 and at least a portion of the subfin 305 may include semiconductor materials of different material compositions. As shown in FIG. 3A, a gate stack having a gate insulator material 112 and a gate electrode material 108 may wrap around channel portions of the nanoribbons 104. FIG. 3A further illustrates a first S/D region 114-1 and a second S/D region 114-2 extending through the nanoribbon stack 204-1, electrically insulated/separated from the gate electrode material 108 and from the semiconductor material 303 of the subfin 305 by an insulator material 307. In some embodiments, the insulator material 307 may form so-called "dimples" 308 in areas where the insulator material 307 separates the S/D regions 114-1, 114-2 from the gate electrode material 108. The insulator material 307 may include any of the insulator materials described herein, e.g., any of the ILD materials described above.

Above the nanoribbon stack 204-1, FIG. 3A illustrates a gate contact 206 and S/D contacts 214 on either side of the gate contact 206, individually labeled as a first S/D contact 214-1 for making electrical contact to the first S/D region 114-1 and a second S/D contact 214-2 for making electrical contact to the second S/D region 114-2. The gate contact 206 may include an electrically conductive material 306 in electrically conductive contact with the gate electrode material 108. In various embodiments, material compositions of the electrically conductive material 306 and the gate electrode material 108 may be substantially the same or different.

The S/D contacts 214 may be electrically isolated from the gate electrode material 108 and the electrically conductive material 306 of the gate contact 206 by gate spacers 308. The gate spacers 308 may include one or more of spacer materials, diffusion barrier materials, adhesion materials, etc., as known in the art for forming contacts to various components of IC structures. In some embodiments, the gate spacers 308 may include low-k dielectrics and/or any of the ILD materials described above. Optionally, sidewalls of the S/D contacts 214 may be lined with one or more liners 310, where the liners 310 may include, but not limited to, materials including silicon and nitrogen (e.g., silicon nitride), materials including silicon and oxygen (e.g., silicon oxide), materials including silicon and carbon (e.g., silicon carbide), and/or their composites. Within the sidewalls, the S/D contacts 214 may be filled with an electrically conductive fill material 314. In various embodiments, material compositions of the electrically conductive fill material 314 and the electrically conductive material 306 may be substantially the same (e.g., both may include/be tungsten) or different. At the bottom of the S/D contacts 214, an interface material 316 is deposited to provide an interface between the S/D regions 114-1, 114-2 and the electrically conductive fill material 314 of S/D contacts 214. The interface material 316 may include/be a metal such as titanium which, once deposited, may intermix with the material of the S/D regions 114-1, 114-2, e.g., with silicon, forming a compound (e.g., titanium silicide) that may help reduce contact resistance of the S/D contacts 214. Although FIG. 3A illustrates an example in which the interface material 316 is only present on the bottom of the S/D contacts 214 and not the sidewalls of the S/D contacts 214, in other examples the interface material 316 may be present on the bottom and sidewalls of the S/D contacts 214. In other embodiments, the interface material 316 is optional and may be absent from the bottom and/or absent from the side walls of the S/D contacts 214.

FIG. 3B shows a cross-sectional side view of the IC structure 200 along the plane BB shown in FIG. 2 and in FIG. 3A (i.e., a gate cut). FIG. 3C shows the plane AA along which the cut of FIG. 3A is shown. Turning to FIG. 3B, the portion 240 illustrates a deep trench via 226, an insulator material 318 surrounding the deep trench via 226, an electrically conductive via fill material 320 filling the deep trench via 226, and an insulator material 322 surrounding sidewalls of the subfin 305. The insulator material 318 and the insulator material 322 may, e.g., include any of the ILD materials described above and may have either substantially the same or different material compositions. The insulator material 322 may sometimes be referred to as a "shallow-trench insulator" (STI). The insulator material 318 is provided to electrically isolate the deep trench via 226 from the adjacent electrically conductive structures and materials, e.g., to electrically isolate the deep trench via 226 from the electrically conductive material 306 of the gate contact 206, which may extend along any of the metal gate lines 205. The electrically conductive via fill material 320 filling the deep trench via 226 may include any suitable conductive material, e.g., tungsten, and may have substantially the same or different material composition with the electrically conductive material 306 of the gate contact 206 and/or with the electrically conductive fill material 314 of the S/D contacts 214.

In some embodiments, sidewalls of the deep trench via 226 may be lined with a liner 324 that includes one or more insulator materials. In one example, the liner 324 is or includes an insulator layer between the conductive via fill material 320 and the insulator material 318. The deep trench via 226 includes a first portion 352 (e.g., a lower or bottom portion) and a second portion 354 (e.g., an upper or top portion). In the example illustrated in FIG. 3B, the first portion 352 is an unlined portion (e.g., the liner 324 is absent on the sidewalls of the portion 352) and the second portion 354 is a lined portion (e.g., the liner 324 is present on the sidewalls of the portion 354). In the example illustrated in FIG. 3B, the portion 354 is coplanar with one or more nanoribbons of the stack 204-1. In one example, in the portion 354, the liner 324 is or includes an insulator layer between the conductive via fill material 320 and the insulator material 322 and between the conductive via fill material 320 and the electrically conductive material 306. The liner 324 may be in contact with the insulator material 318 and/or in contact with the conductive via fill material 320 and/or the insulator material 322, or there may be intervening layers, such as a conductive or semiconductive layer between the liner 324 and the conductive via fill material 320.

The liner 324 may include, but is not limited to, one or more of the ILD materials described above. In some examples, the liner 324 may include silicon oxide, silicon carbide, silicon nitride, a composite including any combination of silicon and one or more of oxygen, nitrogen, and/or carbon (e.g., a composite of silicon, oxygen, and nitrogen, a composite of silicon oxygen, and carbon, a composite of silicon, nitrogen, and carbon, or a composite of silicon, nitrogen, oxygen, and carbon), or any other suitable insulator material.

The liner 324, the insulator material 318, and the insulator material 322 can have the same material properties or different material properties. For example, the liner 324 may include the same or a different material composition than the insulator material 322 and/or the insulator material 318. The liner 324 may have the same or a different density than the insulator material 322 or the insulator material 318.

In one example, the thickness of the liner 324 is sufficiently thick to prevent electrical shorting between the conductive via fill material 320 and adjacent devices (e.g., the conductive material 306), but not so thick as to prevent the via opening from being filled with a sufficient volume of conductive via fill material 320. Thus, the thickness of the liner may depend on a number of factors, including the width of the conductive via 226. In one example, the thickness of the liner is in a range of about 1 to 4 nanometers, or about 2 to 3 nanometers (where the thickness of the liner 324 is a dimension of the liner 324 on the sidewalls of the conductive via 226 in a plane substantially parallel with the support 102). Other liner thicknesses are possible, and it is to be understood that the thickness of the liner 324 may vary at different points along the length of the conductive via.

In one example, due to the lack of liner 324 in the first portion 352, a width of the conductive via 226 (e.g., the width of the via fill material 320 of the conductive via 226) is greater in the first portion 352 than in the second portion 354. For example, the via fill material 320 has a first width 361 in the first portion 352 and a second width 362 in the second portion 354, and the first width 361 is greater than the second width 362. In one such example, the via 226 may have a tapered shape, where the via 226 tapers towards the support 102 (e.g., tapers away from the top nanoribbon of the stack 204-1). In one such example, the via 226 has a first end 366 (e.g., the end further from a top nanoribbon of the stack 204-1 and closer to the subfin 305) and a second end 368 (e.g., the end closer to a top nanoribbon of the stack 204-1 and further form the subfin 305). In one such example, the portion 354 with the liner 324 may be wider at the end 368 than towards the end 366. In one such example, even though the first portion 352 without the liner 324 may have a width 361 that is greater than the width 362 of the second portion 354 with the liner 324, the width 361 may be less than or equal to the width 363 of the portion 354 with the liner at the top end 368 of the via 226.

As can be seen in FIG. 3B, the liner 324 is a partial liner that extends only part way down the length or height of the conductive via 226. For example, the conductive via 226 has a height 370, where the height 370 is a dimension of the conductive via (e.g., a height of a continuous portion of the via fill material 320 of the via 226) in a plane substantially orthogonal to the support 102 or other layer over which the via 226 is disposed (e.g., along the z-axis as shown in FIG. 3B). The extent of the via opening that is lined with the liner 324 may depend on a number of factors, such as the thickness of various layers of the IC structure. For example, the liner 324 may provide an insulator layer between the via fill material 320 of the conductive via 226 and the conductive material 306, and therefore the liner may be present on sidewalls in regions where the conductive material(s) for the gate electrode and/or gate contact are present. In one example, the liner 324 lines about 50-95%, or about 65-90% of the height of the conductive via 226. In one example, the liner 324 ends in a plane with a subfin structure (e.g., the subfin 305). Thus, in one example, the liner extends to a portion of the conductive via 226 that is coplanar with the subfin 305. In one example, the liner extends to a plane between the bottom or end (e.g., the end 366) of the conductive via 226 and the conductive material(s) of the gate stack (e.g., the gate electrode material 108). For example, the liner 324 may extend to (e.g., end at) a distance 375 from the gate electrode material 108, where the distance 375 is in a range of about 10 to 50 nanometers, or about 20 to 40 nanometers. In one example, where the gate electrode material 108 is at a distance 377 from the bottom (e.g., the end 366) of the conductive via 226, the liner 324 may be present on the sidewalls of the conductive via 324 of about 10 to 90 percent of the distance 377, or about 30 to 70 percent of the distance 377. In one example, the subfin 305 has a bottom, a top, and a distance 377 (or height) between the bottom and the top, and the region where the liner ends is about 30 to 70 percent of the distance 377 from the top of the subfin 305.

FIG. 3C provides another helpful illustration of the IC structure 200 along the plane CC shown in FIG. 2 and in FIG. 3A (i.e., a cut across S/D regions of two different nanoribbon stacks 204-1 and 204-2). FIG. 3C shows the plane AA along which the cut of FIG. 3A is shown.

FIG. 3C illustrates the deep trench via 226, an insulator material 318 surrounding the deep trench via 226 as shown in FIG. 3B, a liner 324 including an insulator that extends along a portion of the height of the conductive via 226, and two S/D regions 114-2, one on each side of the deep trench via 226 and electrically insulated from the deep trench via 226 by the insulator material 318. The two S/D regions 114-2 are provided over different ones of the nanoribbon stacks 204-1 and 204-2, as shown in FIG. 2 and FIG. 3C. FIG. 3C further illustrates an insulator material 326 that may surround the S/D regions 114-2, below the electrically conductive fill material 314 of the S/D contacts 214, and may also surround the sidewalls of the subfins 305 of the nanoribbon stacks 204-1 and 204-2. The insulator material 326 may, e.g., include any of the ILD materials described above and may have either substantially the same or different material compositions with any other insulator materials in the IC structure 200, e.g., with the insulator material 322 shown in FIG. 3B. As mentioned above, the liner 324 may have the same or a different material composition than the insulator material 326.

FIG. 4 is a cross-sectional side view illustrating frontside and backside interconnects for the IC structure 200 of FIG. 2, according to some embodiments of the present disclosure. FIG. 4 illustrates the same cross-section of the portion 240 as that shown in FIG. 3B.

FIG. 4 illustrates an IC device 400 that includes a device region 404 with all portions of the IC structure 200 as shown in FIG. 3B, and further including a first interconnect layer 406 formed above the device region 404, and a second interconnect layer 408 formed above the first interconnect layer 406. Additional interconnect layers may be present above the second interconnect layer 408. A collection of interconnect layers such as the interconnect layers 406, 408, etc., may be referred to as a "metallization stack" 419 of the IC device 400. Interchangeably, the metallization stack 419 may be referred to as the "BEOL layer(s)" of the IC device 400, while the device region 404 may be referred to as the "FEOL layer(s)" of the IC device 400.

Electrical signals, such as power and/or input/output (I/O) signals, may be routed to and/or from the devices (e.g., the transistors) of the device region 404 through one or more interconnect layers disposed on the device region 404 (illustrated in FIG. 4 as interconnect layers 406 and 408). For example, electrically conductive features of the device region 404 (e.g., the electrically conductive material 306 of the gate contact 206 and the electrically conductive via fill material 320 of the deep trench via 226) may be electrically coupled with the interconnect structures 428a and 428b of the interconnect layers 406 and 408. The interconnect structures 428a and 428b may be arranged within the interconnect layers of the metallization stack 419 to route electrical signals according to a wide variety of designs (in particular, the arrangement is not limited to the particular configuration of interconnect structures 428a and 428b depicted in FIG. 4). Although a particular number of interconnect layers 406 and 408 is depicted in FIG. 4, embodiments of the present disclosure include IC structures having more or fewer interconnect layers than depicted.

In some embodiments, the interconnect structures may include conductive lines 428a and/or conductive vias 428b filled with an electrically conductive material such as a metal. The lines 428a may be arranged to route electrical signals in a direction of a plane that is substantially parallel with the layer 406. For example, the lines 428a may route electrical signals in a direction in and out of the page from the perspective of FIG. 4. The vias 428b may be arranged to route electrical signals in a direction of a plane that is substantially perpendicular to the layer 406. In some embodiments, the vias 428b may electrically couple lines 428a of different interconnect layers of the metallization stack 419 together.

The interconnect layers 406 and 408 may include a dielectric material 426 disposed between the interconnect structures 428a, 428b, as shown in FIG. 4. In some embodiments, the dielectric material 426 disposed between the interconnect structures 428a, 428b in different ones of the interconnect layers 406 and 408 may have different compositions; in other embodiments, the composition of the dielectric material 426 between different interconnect layers 406 and 408 may be the same.

A first interconnect layer 406 may be formed above the device region 404. In some embodiments, the first interconnect layer 406 may include lines 428a and/or vias 428b, as shown. The lines 428a and/or the vias 428b of the first interconnect layer 406 may be coupled with contacts (e.g., gate contacts 206 and/or S/D contacts 214-1, 214-2 of the IC structure 200) of the device region 404.

A second interconnect layer 408 may be formed above the first interconnect layer 406. In some embodiments, the second interconnect layer 408 may include vias 428b to couple the lines 428a of the second interconnect layer 408 with the lines 428a of the first interconnect layer 406. Although the lines 428a and the vias 428b are structurally delineated with a line within each interconnect layer (e.g., within the second interconnect layer 408) for the sake of clarity, the lines 428a and the vias 428b may be structurally and/or materially contiguous (e.g., simultaneously filled during a dual-damascene process) in some embodiments.

Additional interconnect layers, as desired, may be formed in succession on the second interconnect layer 408 according to similar techniques and configurations described in connection with the second interconnect layer 408 or the first interconnect layer 406. In some embodiments, the interconnect layers that are "higher up" in the metallization stack 419 in the IC device 400 (i.e., farther away from the device region 404) may be thicker. Although not specifically shown in FIG. 4, in some embodiments, the IC device 400 may further include a solder resist material (e.g., polyimide or similar material) and one or more conductive contacts formed on the interconnect layers of the metallization stack 419.

FIG. 4 further includes a metallization stack 449 at the back side of the device region 404. As shown in FIG. 4, the metallization stack 449 may include a first interconnect layer 436 formed on the back side of the device region 404, and a second interconnect layer 438 formed above the first interconnect layer 436. Additional interconnect layers may be present above the second interconnect layer 438.

Electrical signals, such as power and/or input/output (I/O) signals, may be routed to and/or from the devices (e.g., the transistors) of the device region 404 through one or more interconnect layers disposed on the back side of the device region 404 (illustrated in FIG. 4 as interconnect layers 436 and 438). For example, electrically conductive features of the device region 404 (e.g., the electrically conductive via fill material 320 of the deep trench via 226) may be electrically coupled with the interconnect structures 458a, 458b of the interconnect layers 436 and 438. The interconnect structures 458a, 458b may be arranged within the interconnect layers of the metallization stack 449 to route electrical signals according to a wide variety of designs (in particular, the arrangement is not limited to the particular configuration of interconnect structures 458a, 458b depicted in FIG. 4). Although a particular number of interconnect layers 436 and 438 is depicted in FIG. 4, embodiments of the present disclosure include IC structures having more or fewer interconnect layers than depicted.

In some embodiments, the interconnect structures may include conductive lines (e.g., the interconnect structures 458a) and/or conductive vias (e.g., the interconnect structures 458b) filled with an electrically conductive material such as a metal. The interconnect layers 436 and 438 may include a dielectric material 456 disposed between the interconnect structures 458a, 458b, as shown in FIG. 4. Descriptions provided above with respect to the first interconnect layer 406, second interconnect layer 408, metallization stack 419, dielectric material 426, conductive lines (e.g., the interconnect structures 428a), and conductive vias (e.g., the interconnect structures 428b) are applicable to, respectively, the first interconnect layer 436, second interconnect layer 438, metallization stack 449, dielectric material 456, and the interconnect structures 458a, 458b. Therefore, in the interest of brevity, these descriptions are not repeated.

Since the metallization stack 419 is provided on the front side of the device region 404, while the metallization stack 449 is provided on the back side, there may be features indicative of this in the IC device 400. In particular, for certain manufacturing processes, cross-sectional shapes of interconnects in a plane such as that of FIG. 4 (e.g., in a plane substantially perpendicular to the device region 404) may be trapezoidal, i.e., a cross-section of an interconnect may have two substantially parallel sides, one of which shorter than the other. Because the interconnects 428b are formed on a front side 462 of the device region 404, their trapezoidal shapes may be arranged so that their shorter sides are closer to a back side 464 of the device region 404 than their longer sides. Similarly, because the deep trench vias 226 were formed from the same side, the trapezoidal shapes of the deep trench vias 226 may be arranged so that their shorter sides are also closer to a back side 464 of the device region 404 than their longer sides. Because the interconnect structures 458b are formed on the back side 464 of the device region 404, their trapezoidal shapes may be arranged so that their shorter sides are closer to a back side 464 of the device region 404 than their longer sides.

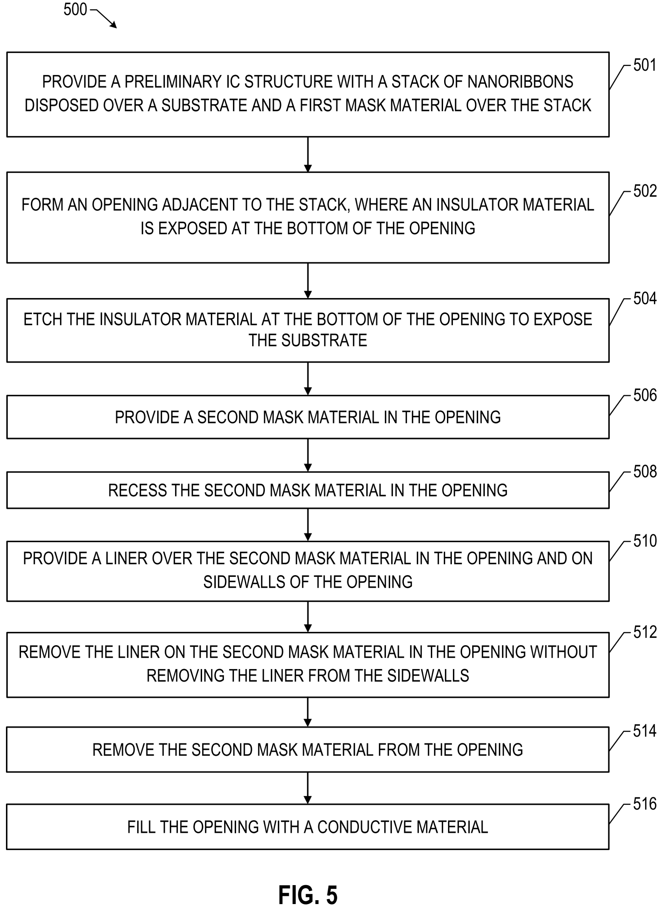

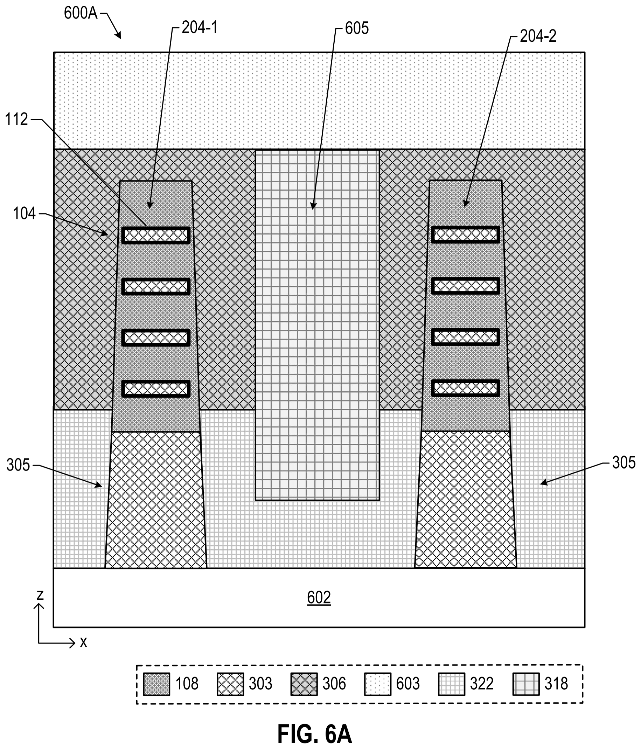

FIG. 5 is a flow diagram of an example method for fabricating an IC structure with deep via formation techniques for backside uniformity, in accordance with some embodiments. FIGS. 6A-6G provide cross-sectional side views at various stages in the fabrication of an example IC structure according to the method of FIG. 5, in accordance with some embodiments.

Although the operations of the method of FIG. 5 are illustrated once each and in a particular order, the operations may be performed in any suitable order and repeated as desired. For example, one or more operations may be performed in parallel to fabricate multiple IC structures fabricated using deep via formation techniques for increased backside uniformity substantially simultaneously. In another example, the operations may be performed in a different order to reflect the structure of an IC device in which an IC structure fabricated using deep via formation techniques for increased backside uniformity will be implemented.

In addition, the example fabricating method of FIG. 5 may include other operations not specifically shown in FIG. 5, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method of FIG. 5 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

Turning to FIG. 5, the method 500 begins with a process 501 of providing a preliminary IC structure with a stack of nanoribbons disposed over a substrate and a first mask material over the stack. An IC structure 600A of FIG. 6A illustrates an example result of the process 501. The IC structure 600A includes a support 602, a first stack 204-1 of nanoribbons and a second stack 204-2 of nanoribbons over the support 602 and adjacent to the first stack 204-1. A mask material 603 is over the stacks 204-1 and 204-2. The support 602 can be, for example, a substrate, a die, a wafer, or a chip, or any other suitable support structure such as those described above with respect to the support 102. The stacks 204-1, 204-2 of nanoribbons are examples of the stack 204-1 of nanoribbons in FIG. 3B. For example, channel portions of the nanoribbons of the stacks 204-1 and 204-2 are at least partially surrounded by a gate electrode material 108. In the example illustrated in FIG. 6A, the IC structure 600A includes the insulator material 322 in the region with the subfins 305 (e.g., on sidewalls of the subfins 305). In the example illustrated in FIG. 6A, an electrically conductive material 306 is over and around the gate electrode material 108. In some examples, one or more further materials, such as the insulator material 318, may be present in a region 605 between the stacks 204-1 and 204-2 (e.g., to electrically isolate the electrically conductive material 306 coupled with the gate electrode material 108 around the stack 204-1 from the electrically conductive material 306 coupled with the gate electrode material 108 around the stack 204-2). The mask material 603 may be any suitable mask material for forming a mask to facilitate forming an opening between the stacks 204-1, 204-2 in the region 605. In one example, the mask material 603 includes polycrystalline silicon.

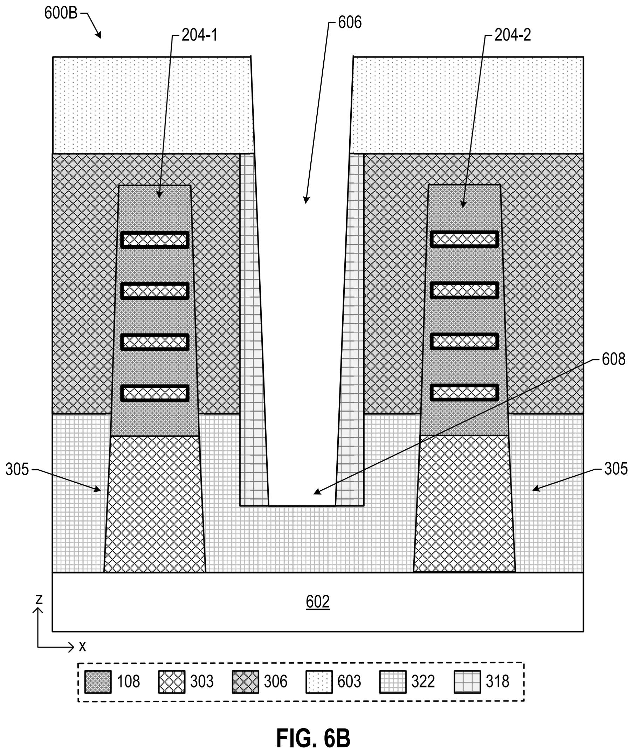

The method 500 continues with a process 502 of forming an opening adjacent to the stack where the insulator material is exposed at the bottom of the opening. An IC structure 600B of FIG. 6B illustrates an example result of the process 502. The IC structure 600B includes an opening 606 between the stack 204-1 and the stack 204-2. In the example illustrated in FIG. 6B, the insulator material 322 is exposed at a bottom 608 of the opening 606. In other examples (e.g., where the insulator material 318 is absent, or where the insulator material 318 extends further into the subfin region), the insulator material 318 may be exposed at the bottom 608 of the opening 606. In the example illustrated in FIG. 6B, the bottom 608 of the opening 606 is below a bottom nanoribbon of the stacks 204-1 and 204-2. In one example, the opening 606 is a trench (e.g., via trench or deep trench). Any suitable etching technique, e.g., a dry etch, such as e.g., radio frequency (RF) reactive ion etch (RIE) or inductively coupled plasma (ICP) RIE may be used for forming the opening 606. In some embodiments, the etch performed in the process 502 may include an anisotropic etch, using etchants in a form of e.g., chemically active ionized gas (i.e., plasma). In some embodiments, during the etch of the process 502, the IC structure may be heated to elevated temperatures, e.g., to temperatures between about room temperature and 200 degrees Celsius, including all values and ranges therein, to promote that byproducts of the etch are made sufficiently volatile to be removed from the surface.

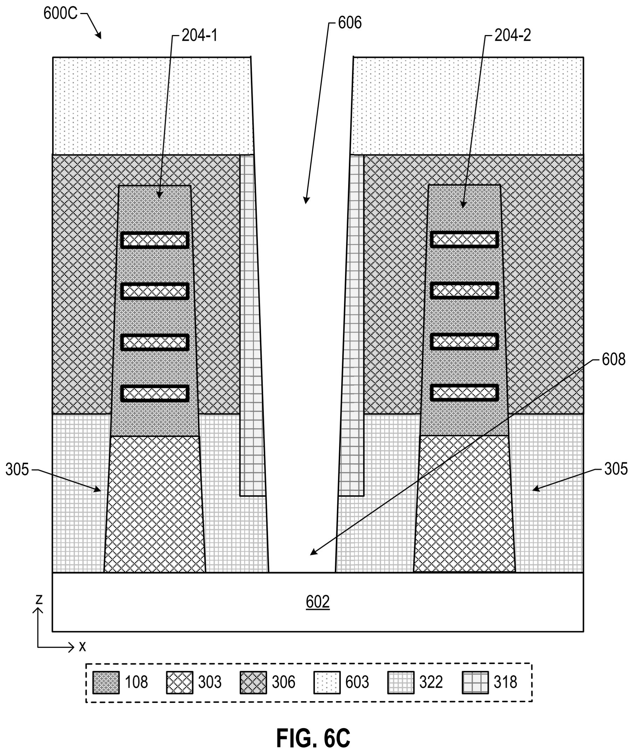

The method may then proceed with a process 504 of etching the insulator material at the bottom of the opening to expose the substrate. An IC structure 600C of FIG. 6C illustrates an example result of the process 504. As can be seen in FIG. 6C, the insulator material 322 at the bottom 608 of the opening 606 has been removed to reveal the semiconductor material of the substrate (e.g., the support 602) at the bottom 608 of the opening. According to examples, the insulator material 322 (or other insulator material present in the opening) is etch selective with respect to the semiconductor material of the support 602 such that an etch process used to etch the insulator material 322 at the bottom 608 of the opening 606 stops on the support 602.

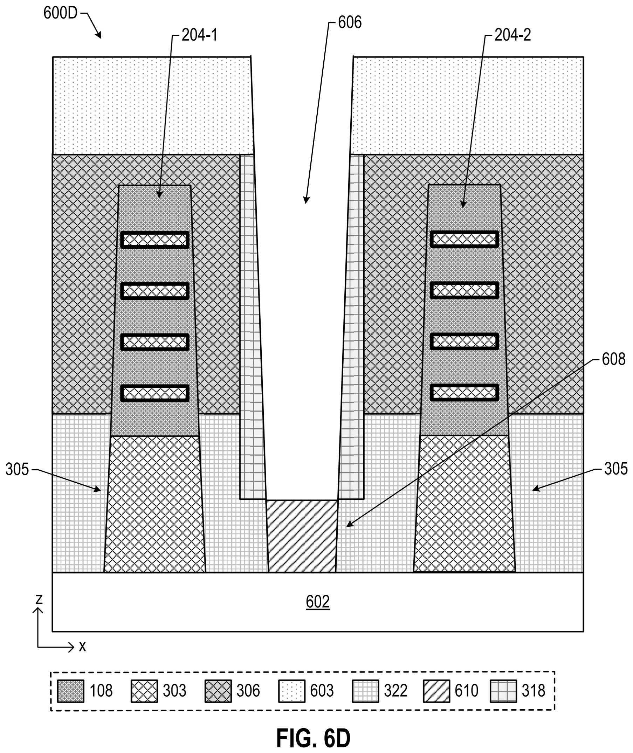

The method may then proceed with a process 506 of providing a second mask material in the opening and a process 508 of recessing the second mask material in the opening. An IC structure 600D of FIG. 6D illustrates an example result of the processes 506 and 508. As can be seen in FIG. 6D, a mask material 610 is present at the bottom 608 of the opening 606. In one such example, the mask material 610 may be deposited over the IC structure 600D such that it fills the opening 606, and then recessed to the desired level. In one example, the mask material 610 is coplanar with the subfins 305 and below the bottom nanoribbon of the stacks 204-1, 204-2. In some examples, the mask material 610 may be any suitable mask material, such as a carbon hard mask or other suitable mask material, and may be provided with any suitable technique (e.g., any suitable deposition and/or etch technique to recess the mask material 610).

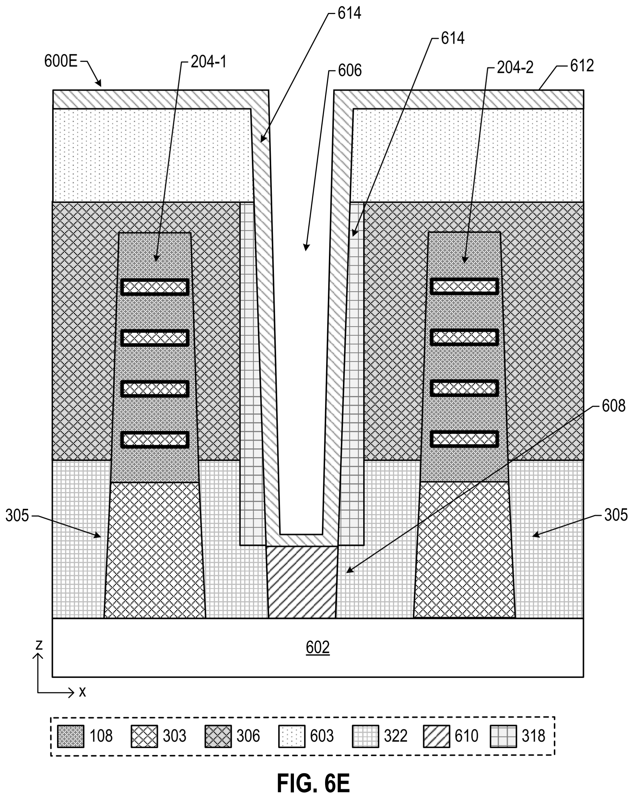

The method may then proceed with a process 510 of providing a liner over the second mask material in the opening and on sidewalls of the opening. An IC structure 600E of FIG. 6E illustrates an example result of the process 510. The IC structure 600E includes a liner 612 on the mask material 610 at the bottom 608 of the opening 606 as well as on the sidewalls 614 of the opening 606 and over the top exposed surfaces of the IC structure (e.g., over the mask material 603). The liner 612 may be an example of the liner 324, discussed above. The liner 612 can be deposited in the process 510 using a technique such as atomic layer deposition (ALD), chemical vapor deposition (CVD), plasma enhanced CVD (PECVD), or/and physical vapor deposition (PVD) processes such as sputter.

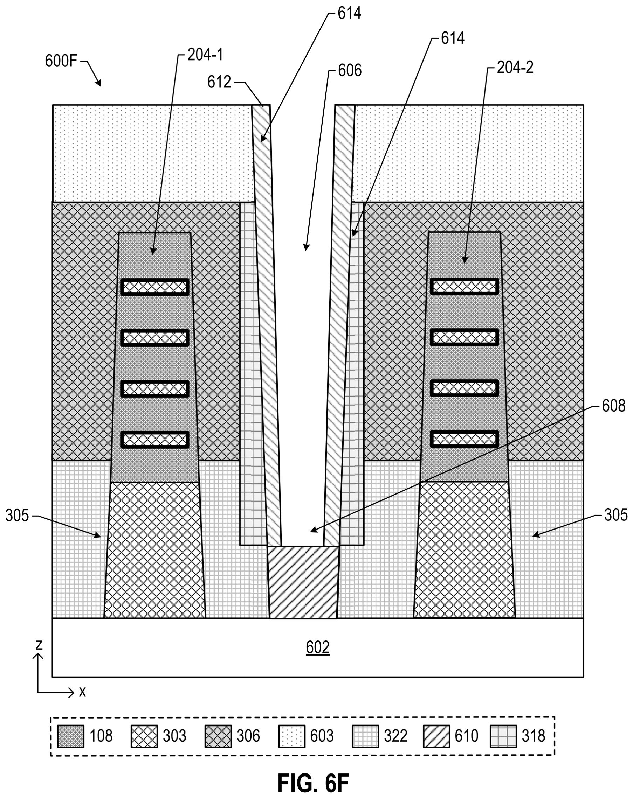

The method may then proceed with a process 512 of removing the liner on the second mask material in the opening without removing the liner from the sidewalls. An IC structure 600F of FIG. 6F illustrates an example result of the process 512. As can be seen in FIG. 6F, the liner 612 remains on the sidewalls 614 of the opening 606, but has been removed from over the mask material 610 at the bottom 608 of the opening 606. The liner 612 may be removed from the bottom of the opening 606 using, e.g., a vertical dry etch process. In some examples, a dry etch process may result in the removal of a small amount of the insulator material of the liner 612 from the sidewalls, but primarily removes the liner 612 at the bottom 608 of the opening 606 and from over the mask material 610 without significantly removing the liner 612 from the sidewalls 614.

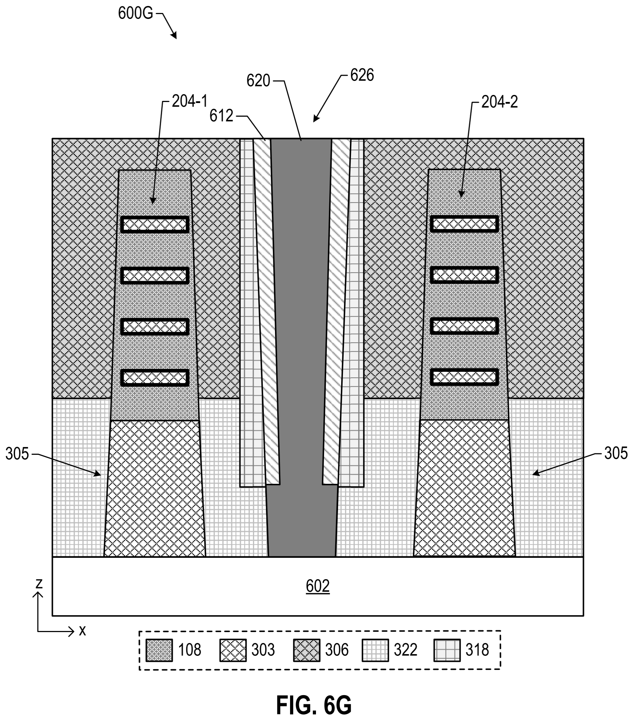

The method may then proceed with a process 514 of removing the second mask material from the opening and a process 516 of filling the opening with a conductive material. An IC structure 600G of FIG. 6G illustrates an example result of the processes 514 and 516. As can be seen n FIG. 6G, the mask material 610 has been removed, and the opening has been filled with a conductive material 620 to form a conductive via 626. Removing the mask material 610 may involve, for example, an ashing process for a carbon hard mask, or other suitable technique for removing the mask material at the bottom of the via opening. The mask material 603 has also been removed from over the IC structure 600G in FIG. 6G. The electrically conductive material 620 may include any suitable electrically conductive material, such as any of those described above, and may be deposited in the process 516 using a technique such as atomic layer deposition (ALD), chemical vapor deposition (CVD), plasma enhanced CVD (PECVD), or/and physical vapor deposition (PVD) processes such as sputter.

The IC structure 600G can then undergo additional processing, for example, to remove the support 602 and form metallization layers over one or both sides of the IC structure 600G to electrically connect the conductive via 626 to other conductive elements and/or devices, such as shown in FIG. 4.

Performing the method 500 may result in features in the final IC structures that are characteristic of the use of the method 500. For example, one such feature is illustrated in the IC structure 600G shown in FIG. 6G, which shows a liner 612 on the sidewalls of the conducive via 626 that includes an insulator material that extends from a top of the conductive via 626 partially down to the bottom of the conductive via 626 so that there is an unlined portion of the conductive via 626 (e.g., towards the bottom of the via). The IC structure 600G also includes a stack 204-1 of two or more nanoribbons stacked over one another, where the conductive via 626 is adjacent to the stack. The conductive via 626 includes a first end and a second end opposite the first end (e.g., where the second end is closer to a top nanoribbon of the stack than the first end), the conductive via has a height between the first end and the second end, and the liner 612 is present on the sidewalls of the conductive via 626, where the liner extends along a portion of the height of the conductive via from the second end to a region between the first end and the second end. Forming deep conductive vias in accordance with examples described herein may reduce defects caused by depth variability of such conductive vias.

IC devices/structures fabricated using deep via formation techniques for increased backside uniformity as described herein (e.g., as described with reference to FIGS. 3A-3C, 4, 5, and 6A-6G) may be used to implement any suitable components. For example, in various embodiments, IC structures described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC devices and structures disclosed herein, e.g., the IC devices/structures 100, 200, or 400, or 600G, or any variations thereof, may be included in any suitable electronic component.

FIGS. 7-10 illustrate various examples of apparatuses that may include any of the IC devices or structures disclosed herein.

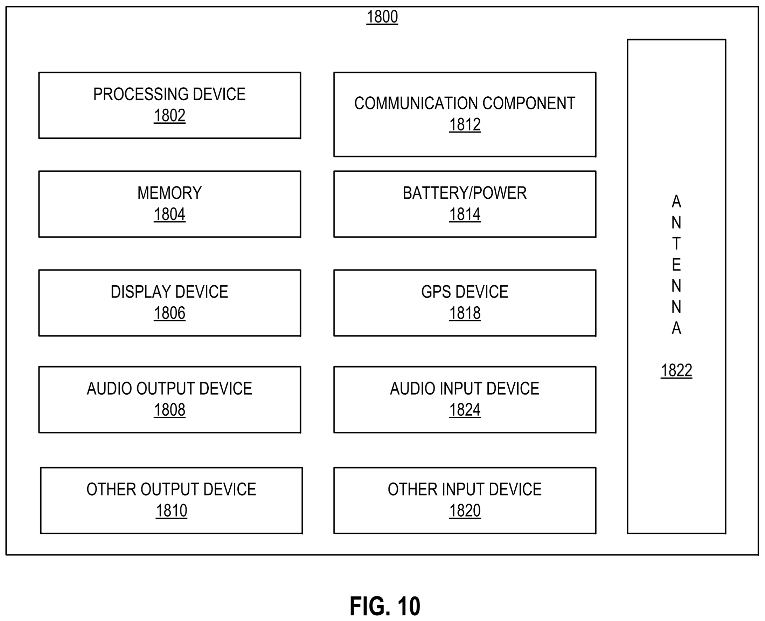

FIG. 7 is a top view of a wafer 1500 and dies 1502 that may include one or more IC structures in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures as described herein (e.g., any of the IC devices/structures 100, 200, or 400, or 600G, described herein), one or more transistors (e.g., nanoribbon transistors of the IC devices/structures 100, 200, 400) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 10) or other logic that is configured to store information in the memory devices or execute instructions stored in the memory array.

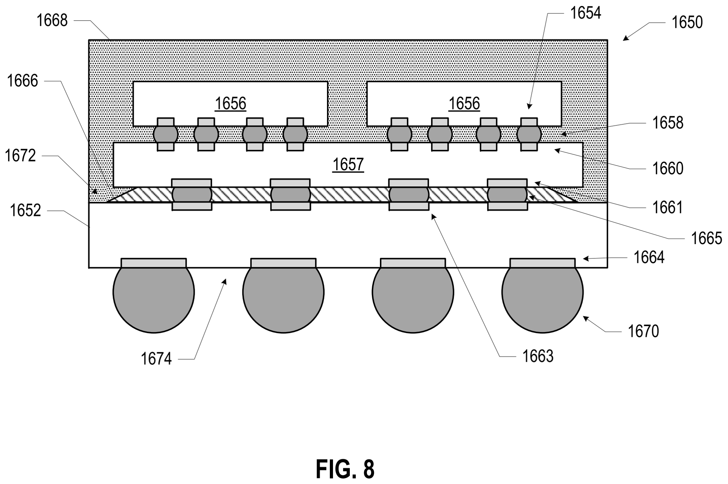

FIG. 8 is a side, cross-sectional view of an example IC package 1650 that may include one or more IC structures in accordance with any of the embodiments disclosed herein (e.g., any of the IC devices/structures 100, 200, or 400, or 600G, described herein). In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnect structures 428a, 428b discussed above with reference to FIG. 4.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 8 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 8 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

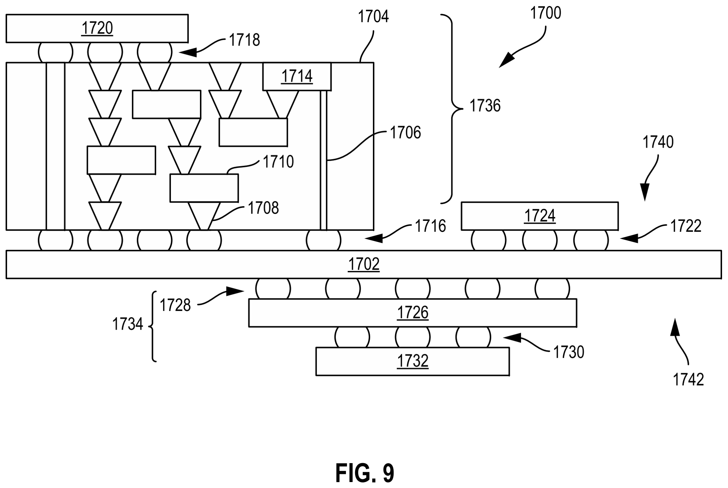

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 8 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 9.

The dies 1656 may take the form of any of the embodiments of the die 1502 discussed herein. In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 8 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 8, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 9 is a side, cross-sectional view of an IC device assembly 1700 that may include one or more IC packages or other electronic components (e.g., a die) including one or more IC devices in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 7 (e.g., may include one or more the IC devices/structures 100, 200, or 400, or 600G).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 9 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 9), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 9, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 7), an IC device (e.g., any of the IC devices/structures 100, 200, or 400, or 600G, described herein, or any combination of such IC devices), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 9, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 9 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 10 is a block diagram of an example electrical device 1800 that may include one or more IC devices/structures 100, 200, or 400, or 600G in accordance with any of the embodiments disclosed herein. For example, any suitable ones of the components of the electrical device 1800 may include one or more of the IC device assemblies 1700, IC packages 1650, or dies 1502 disclosed herein. A number of components are illustrated in FIG. 10 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 10, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include another output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra-mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an integrated circuit (IC) structure, including a first conductive element in a first layer; a second conductive element in a second layer over the first layer; a conductive via between the first conductive element and the second conductive element, where: the conductive via includes a first portion and a second portion, the first portion is coupled with the first conductive element, and the second portion is coupled with the second conductive element and between the first portion and the second conductive element; and a liner including an insulator material on sidewalls of the conductive via, where the liner is limited to the second portion of the conductive via.

Example 2 provides the IC structure of example 1, where: the conductive via includes an electrically conductive material with a first width in the first portion and a second width in the second portion, and the first width is greater than the second width (e.g., the conductive fill material is wider in the portion without the liner).

Example 3 provides the IC structure of any one of examples 1-2, where: the liner is between the electrically conductive material and a further material at the sidewalls of the second portion, and the electrically conductive material is in contact with further material at the sidewalls in the first portion (e.g., the conductive fill material in the via may be in contact with the STI in the portion of the via without the liner).

Example 4 provides the IC structure of any one of examples 1-3, further including a nanoribbon of a semiconductor material coplanar with the second portion of the conductive via.

Example 5 provides the IC structure of example 4, further including a gate electrode material at least partially around the nanoribbon, where: the first portion has a bottom in contact with the first conductive element, and the liner extends about 10 to 80 percent of a distance from the gate electrode material to the bottom.

Example 6 provides the IC structure of any one of examples 4-5, further including a gate electrode material at least partially around the nanoribbon, where: the first portion has a bottom in contact with the first conductive element, and the liner extends about 10 to 50 nanometers from the gate electrode material towards the bottom.

Example 7 provides the IC structure of any one of examples 4-6, where the nanoribbon is a first nanoribbon of a first stack of nanoribbons, and where the IC structure further includes a second stack of nanoribbons adjacent to the first stack of nanoribbons, where the conductive via is between the first stack and the second stack.

Example 8 provides the IC structure of any one of examples 4-7, further including a subfin structure below and substantially aligned with the nanoribbon, where the liner ends in a plane with the subfin structure (e.g., the liner extends to a portion of the via that is coplanar with the subfin structure).

Example 9 provides the IC structure of any one of examples 1-8, where: the liner has a thickness in a range of about 1 to 4 nanometers.

Example 10 provides the IC structure of any one of examples 1-9, where: the insulator material includes silicon and one or more of oxygen and nitrogen.

Example 11 provides an integrated circuit (IC) structure, including a stack of two or more nanoribbons stacked over one another; a conductive via adjacent to the stack, where: the conductive via includes a first end and a second end opposite the first end, where the second end is closer to a top nanoribbon of the stack than the first end, and the conductive via has a height between the first end and the second end; and a liner on sidewalls of the conductive via, where the liner extends along a portion of the height of the conductive via from the second end to a region between the first end and the second end.

Example 12 provides the IC structure of example 11, where: the conductive via includes an electrically conductive material, the liner includes a first insulator material, the first insulator material is between the electrically conductive material and a second insulator material, and the electrically conductive material between the first end and the region is in contact with the second insulator material (e.g., the conductive fill material in the via is in contact with the surrounding insulator material in the portion of the via without the liner).

Example 13 provides the IC structure of any one of examples 11-12, where: the liner extends along about 50-95% of the height of the conductive via.

Example 14 provides the IC structure of any one of examples 11-13, further including a subfin structure below and substantially aligned with the stack, where the region is coplanar with the subfin structure.

Example 15 provides the IC structure of example 14, where: the subfin structure has a bottom, a top, and a distance between the bottom and the top, and the region is about 30 to 70 percent of the distance from the top.

Example 16 provides an IC structure according to any one of examples 1-15, where: the IC structure includes or is a part of a central processing unit.

Example 17 provides an IC structure according to any one of examples 1-16, where: the IC structure includes or is a part of a memory device.

Example 18 provides an IC structure according to any one of examples 1-17, where: the IC structure includes or is a part of a logic circuit.

Example 19 provides an IC structure according to any one of examples 1-18, where: the IC structure includes or is a part of input/output circuitry.

Example 20 provides an IC structure according to any one of examples 1-19, where: the IC structure includes or is a part of a field programmable gate array transceiver.

Example 21 provides an IC structure according to any one of examples 1-20, where: the IC structure includes or is a part of a field programmable gate array logic.

Example 22 provides an IC structure according to any one of examples 1-21, where: the IC structure includes or is a part of a power delivery circuitry.

Example 23 provides an IC package including an IC die including an IC structure according to any one of examples 1-22; and a further IC component, coupled to the IC die.

Example 24 provides an IC package according to example 23, where: the further IC component includes a package substrate.

Example 25 provides an IC package according to example 23, where: the further IC component includes an interposer.

Example 26 provides an IC package according to example 23, where: the further IC component includes a further IC die.

Example 27 provides a computing device including a carrier substrate and an IC structure coupled to the carrier substrate, where the IC structure is an IC structure according to any one of examples 1-22, or the IC structure is included in the IC package according to any one of claims 23-26.

Example 28 provides a computing device according to example 27, where: the computing device is a wearable or handheld computing device.

Example 29 provides a computing device according to examples 27 or 28, where: the computing device further includes one or more communication chips.

Example 30 provides a computing device according to any one of examples 27-29, where: the computing device further includes an antenna.

Example 31 provides a computing device according to any one of examples 27-30, where: the carrier substrate is a motherboard.

Example 32 provides a method of fabricating an IC structure, the method including providing a preliminary IC structure with a stack of nanoribbons over a substrate and a first mask material over the stack; forming an opening adjacent to the stack, where the opening extends to below a bottom nanoribbon of the stack, and where an insulator material is exposed at a bottom of the opening; removing the insulator material at the bottom of the opening; providing a second mask material (e.g., carbon hard mask) in the opening; providing a liner over the second mask material in the opening and on sidewalls of the opening; removing the liner on the second mask material; removing the second mask material in the opening; and filling the opening with an electrically conductive material.

Example 33 provides the method of example 32, further including recessing the second mask material in the opening prior to providing the liner over the second mask material in the opening.

Example 34 provides the method of any one of examples 32-33, where: removing the liner on the second mask material includes an etch process that removes the liner from the second mask material in the opening and from the first mask material without removing the liner from the sidewalls.

Example 35 provides the method of any one of examples 32-34, further including removing the first mask material prior to filling the opening with the electrically conductive material.

Example 36 provides the method of any one of examples 32-35, where: the first mask material includes polysilicon, and the second mask material includes a carbon hard mask.

Example 37 provides a method according to any one of examples 32-36, where the IC structure is an IC structure according to any one of the preceding examples.

Example 38 provides a process of making an IC structure according to the method of any one of examples 32-37.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a first conductive element in a first layer;
a second conductive element in a second layer over the first layer;
a conductive via between the first conductive element and the second conductive element, wherein:
the conductive via comprises a first portion and a second portion,
the first portion is coupled with the first conductive element, and
the second portion between the first portion and the second conductive element and is coupled with the second conductive element; and
a liner comprising an insulator material on sidewalls of the conductive via, wherein the liner is limited to the second portion of the conductive via.

2. The IC structure of claim 1, wherein:
the conductive via comprises an electrically conductive material with a first width in the first portion and a second width in the second portion, and
the first width is greater than the second width.

3. The IC structure of claim 2, wherein:
the liner is between the electrically conductive material and another material at the sidewalls of the second portion, and
the electrically conductive material is in contact with the other material at the sidewalls in the first portion.

4. The IC structure of any one of claims 1-3, further comprising:
a nanoribbon of a semiconductor material coplanar with the second portion of the conductive via.

5. The IC structure of claim 4, further comprising:
a gate electrode material at least partially around the nanoribbon, wherein:
the first portion has a bottom in contact with the first conductive element, and
the liner extends about 10 to 80 percent of a distance from the gate electrode material to the bottom.

6. The IC structure of any one of claims 4-5, further comprising:
a gate electrode material at least partially around the nanoribbon, wherein:
the first portion has a bottom in contact with the first conductive element, and
the liner extends about 10 to 50 nanometers from the gate electrode material towards the bottom.

7. The IC structure of any one of claims 4-6, wherein the nanoribbon is a first nanoribbon of a first stack of nanoribbons, and wherein the IC structure further comprises:
a second stack of nanoribbons adjacent to the first stack of nanoribbons, wherein the conductive via is between the first stack and the second stack.

8. The IC structure of any one of claims 4-7, further comprising:
a subfin structure below and substantially aligned with the nanoribbon, wherein the liner ends in a plane with the subfin structure.

9. The IC structure of any one of claims 1-8, wherein:
the liner has a thickness in a range of about 1 to 4 nanometers.

10. The IC structure of any one of claims 1-9, wherein:
the insulator material comprises silicon and one or more of oxygen and nitrogen.

11. A method of fabricating an integrated circuit (IC) structure, the method comprising:
providing a preliminary IC structure with a stack of nanoribbons over a substrate and a first mask material over the stack;
forming an opening adjacent to the stack, where the opening extends to below a bottom nanoribbon of the stack, and wherein an insulator material is exposed at a bottom of the opening;
removing the insulator material at the bottom of the opening;
providing a second mask material in the opening;
providing a liner over the second mask material in the opening and on sidewalls of the opening;
removing the liner on the second mask material;
removing the second mask material in the opening; and
filling the opening with an electrically conductive material.

12. The method of claim 11, further comprising:
recessing the second mask material in the opening prior to providing the liner over the second mask material in the opening.

13. The method of claims 11 or 12, wherein:
removing the liner on the second mask material comprises an etch process that removes the liner from the second mask material in the opening and from the first mask material without removing the liner from the sidewalls.

14. The method of any one of claims 11-13, further comprising:
removing the first mask material prior to filling the opening with the electrically conductive material.

15. The method of any one of claims 11-14, wherein:
the first mask material comprises polysilicon, and
the second mask material comprises a carbon hard mask.
